# EUROPEAN PATENT APPLICATION

(11) **EP 4 818 686 A1**
(43) Date of publication of application: **07.10.2026**
(21) Application number: 24897000.6
(22) Date of filing: 20.08.2024
(51) Int. Cl.: G01N 24/00, G01N 21/64, G01R 33/20

(54) **OPTICAL NUCLEAR MAGNETIC RESONANCE DEVICE**

(30) Priority: 29.11.2023 JP 2023202036
(71) Applicant: HITACHI HIGH-TECH CORPORATION, Tokyo 105-6409 (JP)
(72) Inventor: YONAMOTO, Yoshiki, Chiyoda, Tokyo 100-8280 (JP); YAMAKAWA, Ichiro, Chiyoda, Tokyo 100-8280 (JP)
(74) Representative: Mewburn Ellis LLP
(86) International application number: PCT/JP2024/029531
(87) International publication number: WO 2025/115308

(57) **Abstract**

There is provided an optical nuclear magnetic resonance device capable of shaping the spatial distribution of the intensity of a laser applied to a diamond (sensor material) from a gaussian shape into a spatially-uniform top-hat shape for shortening the time period necessary for initialization, thereby shortening the measurement time period. The optical nuclear magnetic resonance device 1 includes: a sensor material 101 containing an electron spin that induces electron spin resonance; a laser 102 that the sensor material 101 controls an orientation of the electron spin on a defect contained in the sensor material 101 and measures the orientation of the electron spin; a beam shaping element 105 that controls the laser; a detecting unit that measures a fluorescence emitted from the sensor material due to the laser 102 applied thereto; a microwave irradiation device 103 that applies a microwave to the sensor material 101; a permanent magnet or electromagnet 106 that applies a static magnetic field to the sensor material 101; and a control unit 108 that controls the laser 102, the microwave irradiation device 103, and the beam shaping element 105 so as to uniformize a two-dimensional intensity distribution of the laser 102.

## Description

### Technical Field

The present invention relates to a measurement device using a diamond as a sensor material.

### Background Art

In recent years, there have been suggested optical nuclear magnetic resonance techniques using diamonds. Electron spins existing on a nitrogen-vacancy compound defect (hereinafter referred to as a NV center) existing in a diamond have the property of absorbing light with a wavelength of 532 nm to emit red fluorescence. The intensity of the red fluorescence is determined by the orientations of the electron spins. Further, when there is no static magnetic field applied from the outside, if a microwave with a frequency of about 2.87 GHz is applied to the electron spins, the electron spins absorb the microwave to be brought into an excited state, namely to be changed in orientation. As a result, the intensity of red fluorescence when light with a wavelength of about 532 nm is applied thereto is decreased. This is called an electron spin resonance phenomenon. On the other hand, when there is a static magnetic field applied from the outside, the wavelength of a microwave which is absorbed is proportional to the value of the applied static magnetic field, which changes the wavelength of the microwave which causes the electron spin resonance phenomenon from about 2.87 GHz. Accordingly, by measuring a wavelength dependence of applied microwave, of intensity of red fluorescence when light with about 532 nm is applied, it is possible to quantify the magnetic field intensity sensed by the NV center in the diamond. Further, the wavelength of the microwave which causes the electron spin resonance phenomenon depends not only on the magnetic field intensity, but is changed by an electric field intensity sensed by the diamond, and a temperature therearound. This enables measurements of an electric field intensity and a temperature, in addition to a magnetic field intensity.

Also, rather than temporally continuously applying the microwave and the irradiation light with a wavelength of about 532 nm, by applying them as pulses, it is possible to detect a magnetic field intensity, a temperature and an electric field intensity with higher sensitivity. Further, by using this method of applying pulses for measurement of a magnetic field intensity, it is possible to detect not only a static magnetic field, but also an alternating magnetic field with a certain frequency. In this case, a measurement sequence for a laser and a microwave is a sequence for alternately and repeatedly applying a pulsed laser and a pulsed microwave. Here, the role of the pulsed laser can be divided into two regions, which are temporally former and latter halves. The former half is a region for measuring the intensity of red fluorescence, in order to identify the orientations of the electron spins on the NV center. The latter half is a region for initializing the electron spins on the NV center by the laser, namely for aligning the orientations of all the spins in the same direction.

Here, when there exists a molecule containing hydrogen, fluorine or the like near the NV center in the diamond, it is possible to detect an alternating nuclear magnetic field formed by the atomic nucleus of the hydrogen, fluorine or the like. The detection of such a nuclear magnetic field is a nuclear magnetic resonance method, and is referred to as an optical nuclear magnetic resonance method in the present specification, in order to be distinguished from an ordinary nuclear magnetic resonance method. With the optical nuclear magnetic resonance method, by converting a temporal change of a detected alternating nuclear magnetic field into a frequency, it is possible to calculate the frequency of the nuclear magnetic field. From this frequency, it is possible to determine the molecular structure of the molecule containing hydrogen, fluorine or the like. Further, it is possible to quantify abundance of molecules, from the magnitude of a detected nuclear magnetic field. The optical nuclear magnetic resonance method is known to be more excellent in detection sensitivity than ordinary nuclear magnetic resonance methods.

Patent Literature 1 describes a method for acquiring a magnetic field intensity, by acquiring, through a CCD camera, the wavelength dependence of applied microwave, of intensity of red fluorescence emitted when light with a wavelength of about 532 nm is applied to the diamond containing an NV center.

### Citation List

### Patent Literature

PTL 1: U. S. Patent Application Publication No. 20220050153

### Summary of Invention

### Technical Problem

Patent Literature 1 describes a method for detecting the intensity of red fluorescence emitted from the diamond and a method for analyzing the acquired data.

However, Patent Literature 1 gives no consideration about the influence of the spatial uniformity of the intensity of a laser applied to the diamond, which induces emission of red fluorescence therefrom, on the measured data.

However, as described above, in measurement, it is necessary for operations for initializing the electron spins on the NV center. It is known that, if the initialization is insufficient, this degrades the sensitivity of the measurement of a magnetic field intensity, an electric field intensity and a temperature.

The time period necessary for the initialization is shortened as the intensity of the laser with a wavelength of about 532 nm is increased. However, in general, the laser intensity has a two-dimensional spatial distribution with a Gaussian shape, and the laser beam has a higher light intensity near its center, and has a lower light intensity at a larger distance from its center. That is, the initialization is attained earlier near the center of the laser beam, and is attained later at a larger distance from its center. Hereinafter, such a position at a larger distance from its center will be referred to as a tail. Accordingly, the irradiation time period necessary for sufficient initialization over the entire spot region of the laser applied to the diamond is determined by the time period for initialization of the laser beam tail.

Conventionally, the spatial distribution of the laser intensity has not been taken into consideration. That is, speed control of the initialization time period has been performed at a tail region of the laser beam.

For coping therewith, according to the present invention, there is provided an optical nuclear magnetic resonance device capable of shaping the spatial distribution of the intensity of a laser applied to a diamond (sensor material) from a gaussian shape into a spatially-uniform top-hat shape for shortening the time period necessary for initialization, thereby shortening the measurement time period.

### Solution to Problem

In order to solve the above problems, an optical nuclear magnetic resonance device of the present invention includes: a sensor material containing an electron spin that induces electron spin resonance; a laser that irradiates the sensor material to control an orientation of the electron spin on a defect contained in the sensor material and to measure the orientation of the electron spin; a beam shaping element that controls the laser; a detecting unit that measure a fluorescence emitted from the sensor material due to the laser applied thereto; a microwave irradiation device adapted to apply a microwave to the sensor material; a permanent magnet or electromagnet that applies a static magnetic field to the sensor material; and a control unit that controls the laser, the microwave irradiation device, and the beam shaping element so as to uniformize a two-dimensional intensity distribution of the laser. Advantageous Effects of Invention

According to the present invention, it is possible to provide an optical nuclear magnetic resonance device capable of shaping the spatial distribution of the intensity of a laser applied to a diamond (sensor material) from a gaussian shape into a spatially-uniform top-hat shape, to shorten the time period necessary for initialization, thereby shortening the measurement time period.

Objects, configurations, and effects other than the above will be apparent from the description of the following embodiments.

### Brief Description of Drawings

Fig. 1 is a schematic structure view of an optical nuclear magnetic resonance device in a first embodiment of the present invention.
Fig. 2 is a structure view of a beam shaping element in Fig. 1.
Fig. 3 is an explanation view illustrating a sequence of laser pulses and microwave pulses applied to a diamond (sensor material).
Fig. 4A is an explanation view illustrating a change of red fluorescence, and an amount of signal for measurement, for each laser pulse, in a case where initialization is sufficient.
Fig. 4B is an explanation view illustrating a change of red fluorescence, for each laser pulse, in a case where the initialization is insufficient.
Fig. 5 is an explanation view illustrating a correlation between the number of laser pulses and the red fluorescence intensity, in a case where an initialization time period is changed between 1000 microseconds and 300 microseconds, and in cases where a beam shaping element according to the present invention is used and unused.
Fig. 6 is a view explaining dependency of a red fluorescence intensity at 28th in the laser pulse number in Fig. 5, on the laser pulse latter-half time period (initialization time period) in cases where the beam shaping element according to the present invention is used and unused.

### Description of Embodiments

Hereinafter, embodiments of the present invention will be described based on the drawings. According to the present embodiment, there is provided a process for shaping a spatial intensity distribution of a laser applied to a diamond (sensor material) containing an NV center, from an ordinary Gaussian shape into a spatially-uniform top-hat shape, using an optical element such as a DOE (Diffractive Optical Element), and a beam expander.

According to the present embodiment, the laser to be applied to the diamond (sensor material) can be expanded or reduced in diameter, by the beam expander, to an optimum diameter for the optical element such as a DOE.

According to the present embodiment, the laser having been expanded or reduced by the beam expander is passed through the optical element such as a DOE, so that the laser is shaped into a top-hat shape with a spatially-uniform intensity distribution.

Therefore, according to the present embodiment, the laser with such a spatially-uniform intensity can be applied to the diamond (sensor material), which can reduce the initialization time period, thereby resulting in reduction of the total measurement time period.

Further, measurement to which the present embodiment is applied is magnetic field intensity measurement, optical nuclear magnetic resonance measurement which is an application of magnetic field intensity measurement, temperature measurement, or electric field intensity. Furthermore, although a diamond (sensor material) containing an NV center is described as a sensor material, it is possible to employ any diamonds (sensor materials) containing various centers responsive to a magnetic field, a temperature, and an electric field, including a diamond (sensor material) containing a SiV center, and a diamond (sensor material) containing a GeV center. Furthermore, a DOE is described as an element for shaping the laser as an example, it is possible to employ any optical element capable of shaping a laser into a top-hat shape, such as a fly-eye lens or a diffuser.

Hereinafter, in an example of the present invention, an optical nuclear magnetic resonance device will be described as an example, with reference to the drawings.

### First Embodiment

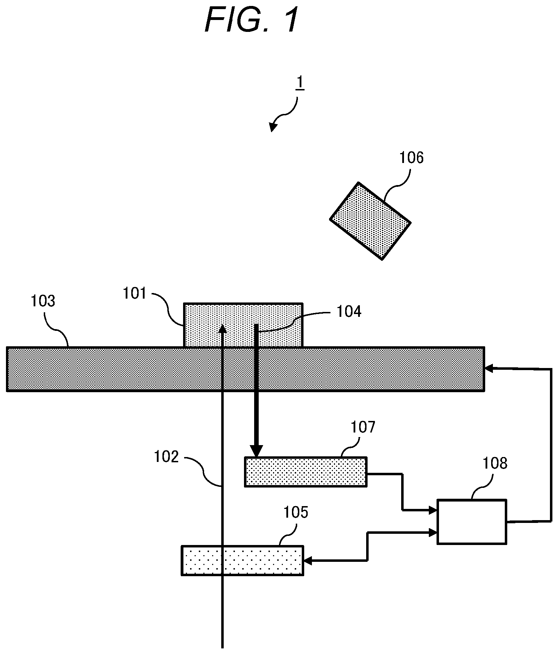

In the present embodiment, there will be described an example where the sensor material is a diamond containing an NV center, the optical element for shaping a laser is a DOE, and the measurement is an optical nuclear magnetic resonance measurement. Fig. 1 is a schematic structure view of an optical nuclear magnetic resonance device in a first example of the present invention. As illustrated in Fig. 1, an optical nuclear magnetic resonance device 1 includes a diamond (sensor material) 101, a laser 102 with a wavelength of about 532 nm which is applied to the diamond (sensor material) 101, a microwave irradiation device 103 that applies a microwave to the diamond (sensor material) 101, a red fluorescence 104 emitted from the diamond (sensor material) 101, a beam shaping element 105 for shaping the laser into a top-hat shape, a permanent magnet or electromagnet 106 installed near the diamond (sensor material) 101 for applying a static magnetic field thereto, a detecting unit 107 for detecting the red fluorescence 104, and a control unit 108. The control unit 108 outputs a microwave pulse command value to the microwave irradiation device 103 that performs irradiation with a microwave, which will be described later. Also, the control unit 108 outputs a laser pulse command value to a laser irradiation device, which is not illustrated. Further, the control unit 108 controls the beam shaping element 105 and, also, receives a detected value inputted from the detecting unit 107. Here, the control unit 108 is realized by, for example, a processor such as a CPU, a ROM for storing various programs, a RAM for temporarily storing data during calculation processing, and a storage device such as an external storage device, which are not illustrated. In the control unit 108, the processor such as a CPU reads and executes the various programs stored in the ROM, and stores the results of calculations as the result of execution into the RAM or the external storage device.

Here, while, in the present embodiment, the laser 102 is applied to the diamond (sensor material) 101 with the microwave irradiation device 103 interposed therebetween, it is not necessarily necessary to interpose the microwave irradiation device 103. Further, the microwave irradiation device 103 is required only to be installed and placed such a position that it can apply a microwave to the diamond (sensor material) 101. Further, the microwave irradiation device 103 can be constituted by either a printed circuit board or a metal wire. Furthermore, the position of the permanent magnet or electromagnet 106 with respect to the diamond (sensor material) 101 is not restricted, provided that the permanent magnet or electromagnet 106 is placed such that it can apply, thereto, a static magnetic field parallel to the bond axis of the NV center contained in the diamond (sensor material) 101. Furthermore, the placement of the detecting unit 107 is arbitrary, provided that the detecting unit 107 is positioned such that it can detect the red fluorescence 104, since the red fluorescence 104 emitted from the diamond (sensor material) 101 is emitted in all directions from the diamond (sensor material) 101. Further, other optical elements such as lenses can be provided in front of or behind the beam shaping element 105, and at a position in front of the detecting unit 107. Further, the wavelength of the laser 102 is not limited to 532 nm, and may be any wavelength that causes the NV center contained in the diamond (sensor material) 101 to emit a red fluorescence.

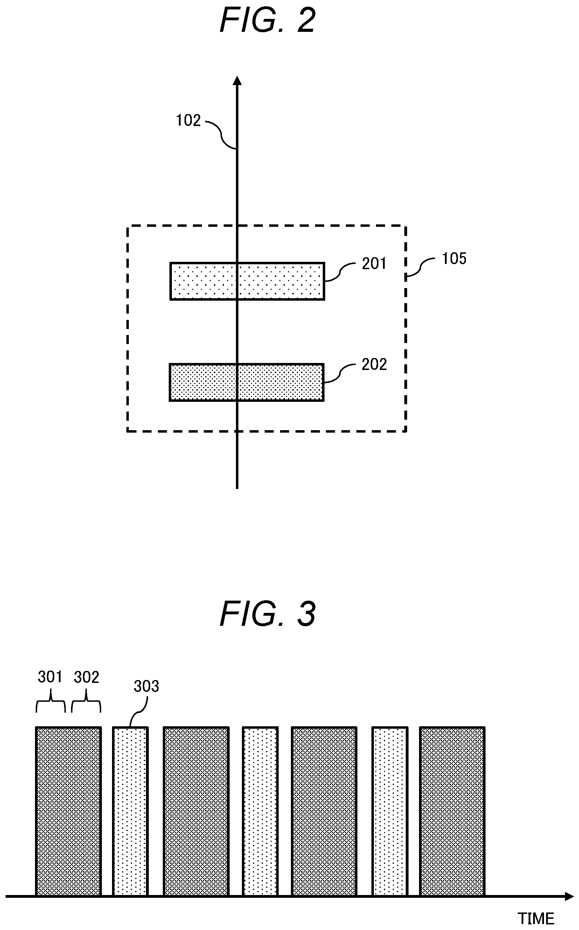

The beam shaping element 105 illustrated in Fig. 1 will be described. Fig. 2 is a structure view of the beam shaping element in Fig. 1. As illustrated in Fig. 2, the beam shaping element 105 includes a DOE 201, and a beam expander 202. The laser 102 passes through the DOE 201 and the beam expander 202, which constitute the beam shaping element 105. Here, the beam expander 202 has a function of increasing or decreasing the spot diameter of the laser 102, and the spot diameter can be optimized according to the specification of the DOE 201 placed downstream thereof. The beam expander 202 may be of any of a Galilean type and a Kepler type, which are representative types. Also, another optical element such as a lens may be placed between the beam expander 202 and the DOE 201.

Here, the DOE 201 will be described. The laser 102 having been expanded or reduced by the beam expander 202 has a slight divergence angle. The laser 102 is shaped into a top-hat shape by being passed through the DOE 201, and the uniformity and the size thereof are influenced by the spot diameter of the laser 102 incident to the DOE 201. Accordingly, in order to optimize the uniformity and the size, the DOE 201 desirably has a mechanism which is movable upstream and downstream. Further, the control unit 108 controls the mechanism which is movable upstream and downstream.

Fig. 3 is an explanation view illustrating a sequence of laser pulses and microwave pulses applied to the diamond (sensor material). That is, Fig. 3 is a view schematically explaining a measurement sequence through optical nuclear magnetic resonance. The laser 102 is applied, as pulses, to the diamond (sensor material) 101, through an AOM (Acoustic Optical Modulator), which is not illustrated. As illustrated in Fig. 3, each pulse of the laser 102 can be temporally divided into following two regions, namely a laser pulse former-half portion 301, and a laser pulse latter-half portion 302. The laser pulse former-half portion 301 is a reading region for measuring the red fluorescence 104 emitted from the diamond (sensor material) 101, by the detecting unit 107. The laser pulse latter-half portion 302 is an initialization region for initializing the orientations of electron spins in the NV center in the diamond (sensor material) 101. After the laser pulse former-half portion 301 and the laser pulse latter-half portion 302, the laser is interrupted, and a microwave pulse 303 is applied from the microwave irradiation device 103 to the diamond (sensor material) 101. Incidentally, the microwave pulse may be constituted by a plurality of pulses, and any pulses may be employed thereas. Subsequently, the microwave pulse is interrupted, and a laser pulse is applied, again, to the diamond (sensor material) 101. As described above, as a measurement sequence through optical nuclear magnetic resonance, there is provided a sequence for repeatedly and alternately applying a laser pulse and a microwave pulse to the diamond (sensor material) 101.

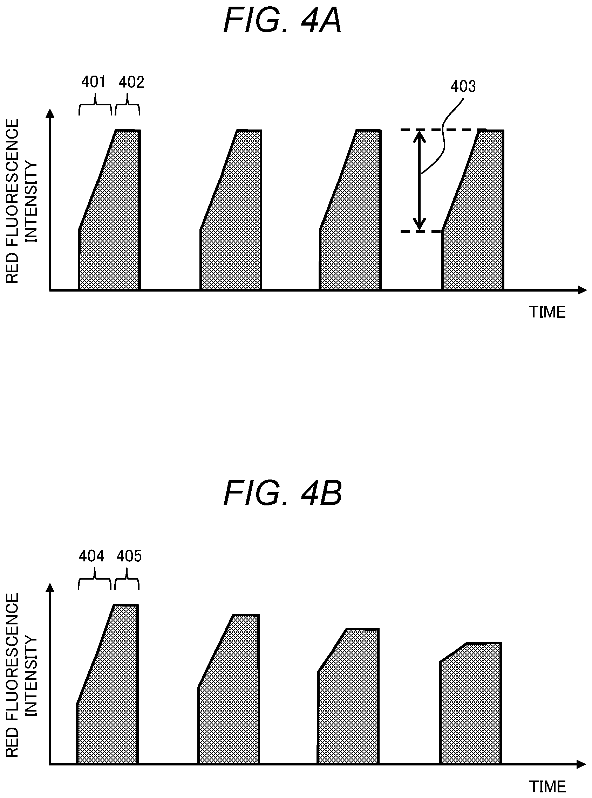

Fig. 4A is an explanation view illustrating a change of the red fluorescence, and an amount of signal for measurement, for each laser pulse, in a case where the initialization is sufficient. That is, Fig. 4 is a view explaining the intensity of the red fluorescence 104 measured by the detecting unit 107, according to the measurement sequence through optical nuclear magnetic resonance, and corresponds to a case where the initialization of the electron spins in the NV center in the diamond (sensor material) 101 is sufficient.

A former-half portion 401 of the red fluorescence intensity in the case where the initialization is sufficient indicates the intensity of the red fluorescence 104 emitted during the former-half portion 301 of the laser pulse. Further, a latter-half portion 402 of the red fluorescence intensity in the case where the initialization is sufficient indicates the intensity of the red fluorescence 104 emitted during the latter-half portion 302 of the laser pulse. In the case of Fig. 4A where the initialization is sufficient, the intensity of the red fluorescence 104 in the latter-half portion 402 of the red fluorescence intensity in the case where the initialization is sufficient has a constant value, without changing with each laser pulse. The difference in intensity of the red fluorescence 104 between the starting point of the former-half portion 401 of the red fluorescence intensity in the case where the initialization is sufficient and the latter-half portion 402 of the red fluorescence intensity in the case where the initialization is sufficient corresponds to a signal intensity 403 of optical nuclear magnetic resonance. Incidentally, there is also an analyzing method using, as a signal intensity, the product of the signal intensity 403 and the time period of the former-half portion 401 of the red fluorescence intensity in the case where the initialization is sufficient, rather than the difference between the starting point of the former-half portion 401 of the red fluorescence intensity in the case where the initialization is sufficient and the latter-half portion 402 of the red fluorescence intensity in the case where the initialization is sufficient. Any of these methods can be employed.

Fig. 4B is an explanation view illustrating a change of the red fluorescence, for each laser pulse, in a case where the initialization is insufficient. That is, Fig. 4B is a view explaining the intensity of the red fluorescence 104 measured by the detecting unit 107, according to the measurement sequence of the optical nuclear magnetic resonance in Fig. 3, and corresponds to a case where the initialization of the electron spins in the NV center in the diamond (sensor material) 101 is insufficient. A former-half portion 404 of the red fluorescence intensity in the case where the initialization is insufficient indicates the intensity of the red fluorescence 104 emitted during the former-half portion 301 of the laser pulse. Further, a latter-half portion 405 of the red fluorescence intensity in the case where the initialization is insufficient indicates the intensity of the red fluorescence 104 emitted during the latter-half portion 302 of the laser pulse. As in Fig. 4B, in the case where the initialization is insufficient, the intensity of the red fluorescence 104 of the initial time of the former-half portion 404 of the red fluorescence intensity in the case where the initialization is insufficient and the intensity of latter-half portion 405 of the red fluorescence intensity in the case where the initialization is insufficient are gradually decreased with each laser pulse. That is, the intensity of the red fluorescence 104 at the initial time of the former-half portion 404 of the red fluorescence intensity in the case where the initialization is insufficient is increased with each laser pulse. On the other hand, the intensity of the red fluorescence 104 in the latter-half portion 405 of the red fluorescence intensity in the case where the initialization is insufficient is gradually decreased with each laser pulse. As in Fig. 4B, in the case where the initialization is insufficient, the signal intensity of optical nuclear magnetic resonance is decreased with each laser pulse. Therefore, it can be understood that sufficient initialization is important.

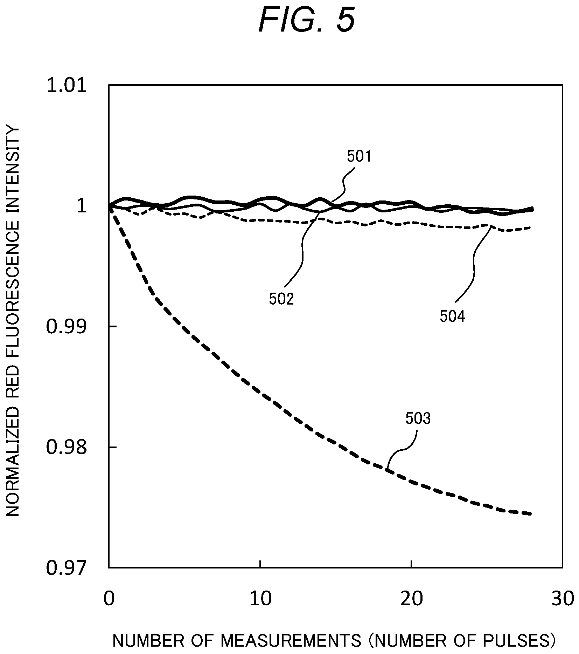

Fig. 5 is an explanation view illustrating the correlation between the number of laser pulses and the red fluorescence intensity, in a case where the initialization time period is changed between 1000 microseconds and 300 microseconds, and in cases where the beam shaping element according to the present invention is used and unused. That is, Fig. 5 is a graph obtained by measuring and plotting, for each laser pulse, the intensity of the red fluorescence 104 in the latter-half portion 402 of the red fluorescence intensity in a case where the initialization is sufficient, and the intensity of the red fluorescence 104 in the latter-half portion 405 of the red fluorescence intensity in a case where the initialization is insufficient. Here, the condition during the measurements in Fig. 5 is that the incident laser intensity is 15 mW, and the interval between laser pulses is 100 microseconds. A number-of-laser-pulses dependency 501 of the latter-half portion of the red fluorescence intensity is measured values in a case where the initialization time period is 1000 microseconds, and the beam shaping element105 is not used. A number-of-laser-pulses dependency 502 of the latter-half portion of the red fluorescence intensity is measured values in a case where the initialization time period is 1000 microseconds, and the beam shaping element105 is used. Further, a number-of-laser-pulses dependency 503 of the latter-half portion of the red fluorescence intensity is measured values in a case where the initialization time period is 300 microseconds, and the beam shaping element 105 is not used. A number-of-laser-pulses dependency 504 of the latter-half portion of the red fluorescence intensity is measured values in a case where the initialization time period is 300 microseconds, and the beam shaping element105 is used. The number-of-laser-pulses dependency 501 of the latter-half portion of the red fluorescence intensity, and the number-of-laser-pulses dependency 502 of the latter-half portion of the red fluorescence intensity have substantially the same value and, also, have constant values, which reveals that the initialization time period of 1000 microseconds is sufficient. On the other hand, the number-of-laser-pulses dependency 503 of the latter-half portion of the red fluorescence intensity has values gradually decreasing with each laser pulse, which reveals that the initialization time period of 300 microseconds is insufficient. However, the number-of-laser-pulses dependency 504 of the latter-half portion of the red fluorescence intensity has values equivalent to those of the number-of-laser-pulses dependency 501 of the latter-half portion of the red fluorescence intensity and the number-of-laser-pulses dependency 502 of the latter-half portion of the red fluorescence intensity, and also has substantially constant values, which reveals that sufficient initialization is attained by the use of the beam shaping element 105 even in the case where the initialization time period is 300 microseconds.

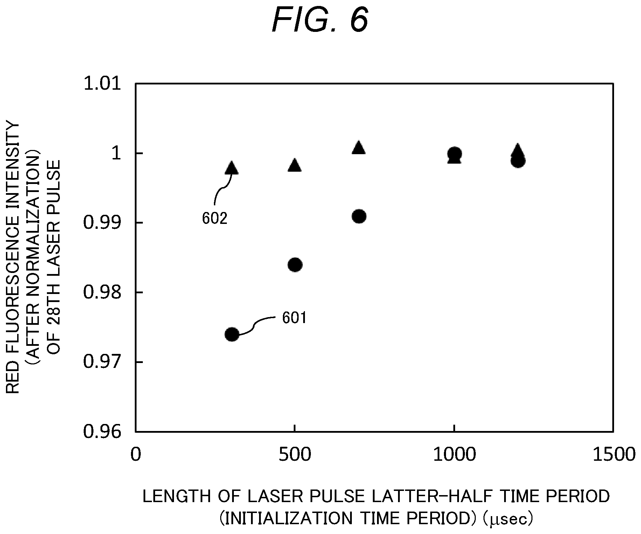

Fig. 6 is a view explaining the dependency of the red fluorescence intensity at 28th laser pulse in Fig. 5, on the laser pulse latter-half time period (initialization time period), in cases where the beam shaping element according to the present invention is used and unused. That is, Fig. 6 is a view obtained by plotting the intensity of the red fluorescence 104 detected during irradiation of the 28th laser pulse, with respect to the initialization time period. Here, the condition during the measurements in Fig. 6 is that the incident laser intensity is 15 mW, and the interval between laser pulses is 100 microseconds, similarly to that of Fig. 5. The laser-pulse-latter-half-time-period (initialization-time-period) dependency 601 of the red fluorescence intensity at 28th of the laser pulse number corresponds to a case where the beam shaping element 105 is not used. The laser-pulse-latter-half-time-period (initialization-time-period) dependency 602 of the red fluorescence intensity at 28th of the laser pulse number corresponds to a case where the beam shaping element 105 is used. First, regarding the laser-pulse-latter-half-time-period (initialization-time-period) dependency 601 of the red fluorescence intensity at 28th of the laser pulse number, it can be seen that the intensity of the red fluorescence 104 prominently decreases, and the shortage of initialization increases, as the initialization time period is decreased. However, when the initialization time period is 1000 microseconds or more, the intensity of the red fluorescence 104 has a substantially constant value, which reveals that sufficient initialization can not be attained without setting the initialization time period at 1000 microseconds or more, in the case where the beam shaping element 105 is not used. On the other hand, regarding the laser-pulse-latter-half-time-period (initialization-time-period) dependency 602 of the red fluorescence intensity at 28th of the laser pulse number, the intensity of the red fluorescence 104 has a substantially constant value regardless of the initialization time period. Therefore, it can be determined that the initialization is sufficient. Accordingly, it is clear that the time period necessary for initialization can be shortened by using the beam shaping element 105.

That is, according to the present embodiment, it is possible to provide an optical nuclear magnetic resonance device capable of shaping the spatial distribution of the intensity of the laser applied to the diamond (sensor material), from a Gaussian shape into a spatially-uniform top-hat shape, for shortening the time period necessary for initialization, thereby shortening the measurement time period.

Specifically, according to the present embodiment, by shaping the laser into a top-hat shape, it is possible to uniformize the spatial distribution of the laser intensity, thereby shortening the time period necessary for initializing the electron spins at the NV center in the diamond (sensor material). This clearly makes it possible to shorten the total measurement time period through optical nuclear magnetic resonance.

It should be noted that the present invention is not limited to the embodiments described above, and includes various modification examples.

For example, the embodiments described above have been described in detail to simply describe the present invention, and are not necessarily required to include all the described configurations.

### Reference Signs List

1: optical nuclear magnetic resonance device
101: diamond (sensor material)
102: laser
103: microwave irradiation device
104: red fluorescence
105: beam shaping element
106: permanent magnet or electromagnet
107: detecting unit
108: control unit
201: DOE (Diffractive Optical Element)
202: beam expander
301: laser pulse former-half portion
302: laser pulse latter-half portion
303: microwave pulse
401: former-half portion of red fluorescence intensity in case where initialization is sufficient
402: latter-half portion of red fluorescence intensity in case where initialization is sufficient
403: signal intensity
404: former-half portion of red fluorescence intensity in case where initialization is insufficient
405: latter-half portion of red fluorescence intensity in case where initialization is insufficient
501, 502, 503, 504: number-of-laser-pulses dependency of latter-half portion of red fluorescence intensity
601, 602: laser-pulse latter-half time-period (initialization-time-period) dependency of red fluorescence intensity at 28th of pulse number

## Claims

1. An optical nuclear magnetic resonance device comprising:
a sensor material containing an electron spin that induces electron spin resonance;
a laser that irradiates the sensor material to control an orientation of the electron spin on a defect contained in the sensor material and to measure the orientation of the electron spin;
a beam shaping element that controls the laser;
a detecting unit that measures a fluorescence emitted from the sensor material due to the laser applied thereto;
a microwave irradiation device that applies a microwave to the sensor material;
a permanent magnet or electromagnet that applies a static magnetic field to the sensor material; and
a control unit that controls the laser, the microwave irradiation device, and the beam shaping element so as to uniformize a two-dimensional intensity distribution of the laser.

2. The optical nuclear magnetic resonance device according to claim 1, wherein
the beam shaping element shapes a spatial distribution of an intensity of the laser from a non-uniform gaussian shape into a uniform top-hat shape.

3. The optical nuclear magnetic resonance device according to claim 2, wherein
the beam shaping element includes:
at least one of a diffractive optical element, a diffuser, or a fly-eye lens; and
a beam expander that optimizes a spot diameter of the laser incident to at least the one of the diffractive optical element, the diffuser, or the fly-eye lens.

4. The optical nuclear magnetic resonance device according to claim 3, wherein
the detecting unit detects an alternating magnetic field emitted from a nuclear spin in an element contained in a to-be-measured sample.
